# FASCICULE DE BREVET EUROPEEN

(11) **EP 3 405 977 B1**
(45) Date de publication et mention de la délivrance du brevet: **18.12.2019**
(21) Numéro de dépôt: 17700445.4
(22) Date de dépôt: 16.01.2017
(51) Int. Cl.: H01L 27/148, H04N 5/372

(54) **CAPTEUR D'IMAGE MULTILINÉAIRE À TRANSFERT DE CHARGES À RÉGLAGE DE TEMPS D'INTÉGRATION**
MEHRREIHIGER BILDSENSOR MIT LADUNGSÜBERTRAGUNG MIT INTEGRATIONSZEITANPASSUNG
MULTILINEAR IMAGE SENSOR WITH CHARGE TRANSFER WITH INTEGRATION TIME ADJUSTMENT

(30) Priorité: 22.01.2016 FR 1650511
(43) Date de publication de la demande: 28.11.2018
(73) Titulaire: Teledyne E2V Semiconductors SAS, 38120 Saint-Egrève (FR)
(72) Inventeur: BARBIER, Frédéric, 38120 Fontanil-Cornillon (FR); MAYER, Frédéric, 38500 Voiron (FR); FEREYRE, Pierre, 38340 Voreppe (FR)
(74) Mandataire: Desvignes, Agnès
(86) Numéro de dépôt international: PCT/EP2017/050815
(87) Numéro de publication internationale: WO 2017/125356

(56) Documents cités:
- JP-A- 2012 234 921
- US-B1- 6 465 820
- US-B1- 6 486 503

## Description

### DOMAINE TECHNIQUE

L'invention concerne les capteurs d'image linéaire à défilement et intégration de signal (ou capteurs d'image TDI, de l'anglais : "Time Delay Integration Linear Sensors"), dans lesquels une image d'une ligne de points d'une scène observée est reconstituée par addition de signaux recueillis par plusieurs lignes de pixels photosensibles observant successivement une même ligne de la scène au fur et à mesure que la scène défile devant le capteur.

### ETAT DE LA TECHNIQUE

Ces capteurs sont utilisés par exemple dans des scanners. Ils comprennent une barrette de plusieurs lignes parallèles de pixels photosensibles ; le séquencement des circuits de commande des différentes lignes (contrôle de temps d'exposition puis de lecture des charges photogénérées) est synchronisé par rapport au défilement relatif de la scène et du capteur, de manière que toutes les lignes de pixels du capteur voient successivement une même ligne de la scène observée. Les signaux générés par chaque ligne sont ensuite additionnés point à point pour chaque point de la ligne observée.

A temps d'exposition constant, la sensibilité du capteur est améliorée dans le rapport du nombre N de lignes, ou bien, à sensibilité constante, le temps d'exposition peut être divisé par N. Ce nombre N peut être par exemple de 16 ou 32 pour des applications de contrôle industriel. Le rapport signal/bruit est amélioré dans le rapport de la racine carrée du nombre N de lignes du capteur.

Il existe des capteurs d'image TDI dans lesquels les pixels sont des pixels actifs comportant une photodiode et plusieurs transistors, et dans lesquels l'addition de signaux issus des pixels se fait numériquement, c'est-à-dire que le signal analogique issu de chaque pixel est numérisé, et les valeurs numériques issues de pixels ayant vu le même point d'image sont ensuite additionnées.

Il existe également des capteurs d'image TDI à transfert de charges où les pixels sont passifs (comportant seulement des zones de génération de charges et de stockage de charges) dans lesquels l'addition des signaux point à point est une addition de charges électriques recueillies par les différents pixels ayant vu le même point d'image. Cette addition se fait simplement en vidant dans une ligne de pixels les charges générées et accumulées dans la ligne de pixels précédente, en synchronisme avec le déplacement relatif de la scène et du capteur. La dernière ligne de pixels, ayant accumulé N fois les charges engendrées par la ligne d'image observée, peut être lue et c'est alors qu'elle peut être numérisée.

De tel capteurs sont majoritairement réalisés en technologie CCD et seront progressivement réalisés en technologie CMOS. Chaque pixel comporte des grilles de stockage des charges électriques générées par la lumière. Les charges sont générées dans le semiconducteur recouvert par les grilles, ou dans des photodiodes parfois intercalées entre deux grilles successives. Le capteur comporte des moyens de commande des potentiels appliqués aux grilles pour déplacer les charges électriques d'une grille à l'autre, simultanément pour tous les pixels, au cours de N étapes successives s'il y a N lignes dans le capteur TDI.

Un exemple de capteur TDI à transfert de charge est donné dans brevet EP 2 482 317. Dans cet exemple, le pixel comporte une succession de grilles et de photodiodes, par exemple quatre grilles et quatre photodiodes alternées, avec un dopage uniforme du semiconducteur sous les grilles ; la commande des grilles comporte quatre phases ; le pixel peut également comporter une alternance de trois grilles et trois photodiodes et une commande à trois phases. Un autre exemple est donné dans le brevet US 6 465 820. Dans cet autre exemple, un pixel comporte seulement une grille et une photodiode et la commande des grilles comporte deux phases seulement en raison des dopages particuliers prévus dans le semiconducteur, aussi bien dans la photodiode que sous la grille.

Dans ces différents exemples, le semiconducteur est photosensible, aussi bien sous les grilles que dans les photodiodes, c'est-à-dire que la lumière éclairant le pixel engendre des charges électriques représentatives de cet éclairement aussi bien sous les grilles que sous les photodiodes. Selon la phase considérée lors du transfert de charge, les charges photogénérées viennent se stocker soit sous les grilles soit sous les photodiodes, soit encore sous les deux à la fois. La succession des phases transfère progressivement les charges d'une région de stockage à une autre située en aval de la première.

Le brevet JP 2012 234921 propose une autre structure de capteur TDI à transfert de charge qui propose des pixels pour l'intégration de charges répondant à différentes longueurs d'onde lumineuse dans une partie détection, et des pixels pour la transmission uniquement, protégés de la lumière, dans une partie transfert entre la partie détection et le circuit de lecture.

La présente invention concerne les capteurs TDI à transfert de charges par opposition aux capteurs à sommation numérique.

On s'est aperçu que ces capteurs à transfert de charges pouvaient avoir un inconvénient lorsque la vitesse de défilement relatif du capteur et de l'image fluctue. En effet, la période de fonctionnement cyclique des pixels est réglée exactement sur la vitesse de défilement pour avoir un vrai fonctionnement TDI. Lorsque le défilement est imposé par un mécanisme extérieur au capteur, par exemple pour l'observation d'objets placés sur un tapis roulant, on asservit en général le fonctionnement des phases du capteur sur la vitesse de défilement du tapis et la période T_{L} de transfert de charges d'une ligne de pixels à la suivante, qu'on peut appeler "temps ligne" est asservie à la vitesse de défilement. Des fluctuations dans la vitesse de défilement peuvent se produire et elles sont compensées : le fonctionnement TDI n'est pas perturbé car les lignes successives de pixels verront toujours la même hauteur de ligne physique sur la scène en raison de l'asservissement effectué. Le temps d'intégration de la lumière, égal au temps ligne T_{L}, est égal à D/V si la vitesse de défilement relatif de l'image projetée sur les pixels est V et si le pas des lignes de pixels est D.

Si la vitesse de défilement V varie, le temps d'exposition variera en conséquence, en proportion inverse de la vitesse. La durée d'exposition des lignes de pixels varie donc en fonction des fluctuations du défilement, ce qui entraine des perturbations dans la fidélité de l'image produite par le capteur,

Il y a des circonstances dans lesquelles on veut éviter des fluctuations de temps d'exposition, par exemple dans un appareil d'observation d'objets défilant sur un tapis roulant. Au démarrage du tapis, et même en cours de fonctionnement, la vitesse peut fluctuer très significativement et perturber l'image recueillie.

On s'est donc aperçu qu'il pouvait être souhaitable dans certains cas de décorréler le temps d'intégration T_{INT} de la lumière et le temps ligne T_{L}. Dans les pixels des capteurs TDI à transfert de charge de l'art antérieur, il n'y a pas de possibilité de rendre la durée d'intégration de charges T_{INT} plus petite que la durée de ligne T_{L}.

### RESUME DE L'INVENTION

L'invention propose donc un capteur d'image TDI à transfert de charge dont les pixels sont construits de manière à permettre d'établir une durée d'intégration de lumière T_{INT} variable, inférieure ou égale à la durée T_{L} de périodicité de transfert de charges d'une ligne de pixels à la suivante.

Pour cela, le pixel est divisé en au moins deux parties, dans le sens du transfert de charges de ligne à ligne, chaque partie étant apte à stocker des charges électriques, l'une des parties étant masquée de la lumière, et l'autre partie étant non masquée. La partie non masquée est pourvue d'une structure d'évacuation de charges, qui peut être commandée pour évacuer et faire disparaître des charges stockées dans cette partie. L'évacuation de charges stockées dans la partie non masquée n'entraîne pas l'évacuation de charges dans la partie masquée ; cette dernière conserve les charges qui ont été intégrées pendant une période précédente ; l'intégration effective de charges dans la partie non masquée ne commence qu'après la fin d'une commande d'évacuation de charges puisque les charges éventuellement recueillies dans cette partie non masquée disparaissent lors de cette commande. Ainsi, le temps d'intégration de charges peut-il être limité à une durée inférieure à la période de ligne sans que cela entraîne la disparition des charges provenant des pixels des lignes précédentes, ces dernières restant provisoirement stockées dans la partie non masquée sans que l'évacuation des charges de la partie non masquée agisse sur elles.

Par conséquent, l'invention propose un capteur d'image à transfert de charges fonctionnant en défilement et intégration de charges, le capteur comportant N lignes adjacentes de P pixels en vue d'une observation d'une même ligne d'image successivement par plusieurs lignes de pixels avec une sommation des charges électriques générées par un point d'image pendant une durée périodique de ligne dans les pixels de même rang des différentes lignes, les pixels comportant chacun une succession, dans le sens du défilement, de zones de stockage de charges dont certaines au moins sont photosensibles, le capteur comportant des moyens de commande pour appliquer à ces zones des potentiels permettant le stockage puis le transfert directionnel de charges d'un pixel au suivant, caractérisé en ce que chaque pixel est subdivisé, dans le sens du défilement, en au moins deux parties adjacentes, chaque partie comportant au moins une zone de stockage de charges indépendante des zones de stockage de l'autre partie mais permettant un transfert de charges de la première partie vers la deuxième, l'une des parties étant masquée contre la lumière, et l'autre partie n'étant pas masquée contre la lumière, cette dernière comprenant au moins une zone de stockage photosensible et structure d'évacuation de charges permettant de supprimer les charges stockées dans cette autre partie, la structure d'évacuation de charges étant activée au cours d'une fraction d'une durée de ligne, avant un instant réglable de début d'intégration effective précédant une étape de transfert de charges de la partie masquée vers la partie non masquée.

L'invention s'applique à toutes les structures TDI de capteur à transfert de charges, quel que soit le nombre de zones de stockage dans le pixel (au moins deux zones pour permettre un transfert) et quel que soit le nombre de phases de fonctionnement permettant le transfert de charges d'un pixel à un autre pendant une période de ligne T_{L}. Elle s'applique aussi bien lorsque les zones de stockage sont des grilles conductrices isolées surmontant une portion de substrat semi-conducteur que lorsque les zones de stockage sont des photodiodes, et notamment des photodiodes dites "pinned", c'est-à-dire des photodiodes ayant un potentiel de surface fixe. Dans une réalisation avantageuse, le pixel d'un capteur selon l'invention pourra comporter trois grilles adjacentes se succédant dans le sens du défilement, la première grille étant masquée de la lumière et constituant la première partie du pixel et les deux autres étant éclairées et constituant la deuxième partie du pixel, la structure d'évacuation de charges étant adjacente auxdites deux autres grilles. Dans une autre réalisation avantageuse, la première partie du pixel comportera successivement, dans le sens du défilement, deux grilles et une photodiode, et la deuxième partie comportera également deux grilles et une photodiode, et la structure d'évacuation de charges est adjacente à la photodiode de la deuxième partie.

L'invention porte également sur un procédé de fonctionnement d'un capteur d'image TDI à transfert de charge fonctionnant en défilement et intégration de charges, dont les pixels sont divisés en une partie masquée et une partie non masquée. Dans le procédé selon l'invention, le capteur comporte N lignes adjacentes de P pixels en vue d'une observation d'une même ligne d'image successivement par plusieurs lignes de pixels avec une sommation des charges électriques générées par un point d'image pendant une durée de ligne T_{L} dans les pixels de même rang des différentes lignes, les pixels comportant chacun une succession, dans le sens du défilement, de zones de stockage de charges dont certaines au moins sont photosensibles, le capteur comportant des moyens de commande pour appliquer à ces zones des potentiels permettant le stockage puis le transfert directionnel de charges d'un pixel amont vers un pixel aval, caractérisé en ce qu'une partie des zones de stockage de chaque pixel est masquée de la lumière et une autre partie est non masquée et est photosensible, et en ce que le défilement et l'intégration de charges comprennent, cycliquement avec une périodicité égale à une durée de ligne T_{L} :
- le déversement de charges issues du pixel amont dans une zone de stockage de la partie masquée du pixel aval,
- une commande de vidage, vers un drain d'évacuation, des charges contenues dans la partie non masquée du pixel aval, puis l'interruption de cette commande, définissant un instant de début d'intégration effective de charges dans le pixel aval,
- simultanément ou séparément, l'intégration de charges photogénérées dans la partie non masquée du pixel aval et le déversement vers la partie non masquée du pixel aval, des charges stockées dans la partie masquée du pixel aval.

D'autres caractéristiques et avantages de l'invention apparaîtront à la lecture de la description détaillée qui suit et qui est faite en référence aux dessins annexés dans lesquels :
- la figure 1 donne un exemple de structure de pixel de capteur TDI selon l'invention à trois grilles de stockage par pixel, dont l'une est masquée de la lumière ;
- la figure 2 représente un chronogramme de fonctionnement du pixel de la figure 1 ;
- la figure 3 représente une structure de pixel de capteur selon l'invention, à deux subdivisions comportant chacune deux grilles de stockage et une photodiode ;
- la figure 4 représente un chronogramme de fonctionnement du pixel de la figure 3.

### DESCRIPTION DETAILLEE

L'invention va d'abord être décrite dans un cas particulièrement simple où toutes les zones de stockage de charges sont constituées à l'aide de grilles conductrices isolées, et les charges sont générées dans le substrat semiconducteur sous-jacent par la lumière qui traverse les grilles isolées (en général en silicium polycristallin). Mais l'invention s'applique aussi, comme on le verra, dans le cas où certaines des zones de stockage sont des photodiodes.

D'une manière générale les pixels photosensibles d'un capteur d'image sont formés dans un substrat semiconducteur dont la partie supérieure est une couche semiconductrice épitaxiale peu dopée. Le substrat est par exemple fortement dopé de type p et la couche épitaxiale est de type p mais moins dopée et les potentiels appliqués aux grilles pour former des puits de potentiel capables de retenir des charges sont des potentiels positifs alors que les potentiels appliqués aux grilles pour former des barrières de potentiel sont en général des potentiels nuls ou négatifs, la référence de potentiel zéro étant le potentiel de la couche épitaxiale.

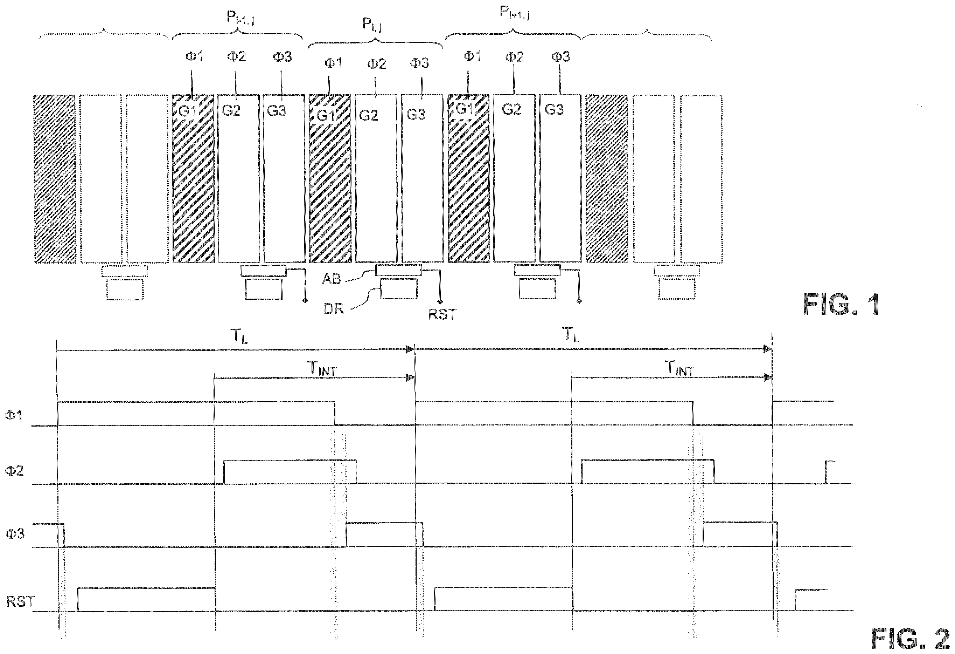

Sur la figure 1, on a représenté le cas d'un capteur d'image dont les pixels sont constitués chacun par trois grilles adjacentes se succédant dans le sens du transfert des charges, c'est-à-dire dans le sens du défilement relatif du capteur par rapport à l'image à observer projetée sur le capteur, qui est le sens des colonnes de pixels, perpendiculaire au sens des lignes de pixels.

Trois pixels successifs appartenant à une même colonne de rang j sont représentés schématiquement en vue de dessus. Ils sont désignés par P_{i-1,j} ; P_{i,j} ; et P_{i+1,j} pour indiquer qu'ils appartiennent respectivement à trois lignes successives de rang i-1, i, et i+1. Les pixels des autres colonnes ne sont pas représentés ; il n'y a pas de transfert de charges entre les pixels de colonnes différentes.

Chaque pixel comporte trois grilles adjacentes G1, G2, G3 se succédant dans le sens du transfert de charges et correspondant à trois zones de stockage possibles, dans le semi-conducteur sous la grille respective, pour les charges qui circulent d'une ligne de pixels à une autre. Les grilles sont commandées par des signaux respectifs Φ1 pour la grille G1, Φ2 pour la grille G2, et Φ3 pour la grille G3, signaux qui sont les mêmes pour tous les pixels. La dernière grille G3 d'un pixel amont est adjacente à la première grille G1 d'un pixel aval pour permettre le transfert de charges d'un pixel au suivant. Les signaux de commande Φ1, Φ2, Φ3 appliqués à une grille G1, G2 ou G3 permettent, en fonction des autres signaux appliqués aux grilles qui lui sont adjacentes, soit de stocker des charges sous cette grille soit de transférer des charges vers une autre grille (du même pixel ou d'un pixel adjacent).

Selon l'invention, les pixels sont subdivisés en deux parties. Des charges électriques peuvent être stockées indépendamment dans chacune des deux parties. L'une des parties est masquée de la lumière, par exemple par une métallisation opaque ; l'autre est exposée à la lumière. Dans l'exemple représenté, la première partie correspond essentiellement à la première zone de stockage (grille G1) ; la représentation hachurée des grilles G1 signifie ici que la grille est soit en matériau opaque soit de préférence masquée de la lumière par une couche opaque ; en pratique la grille est en silicium polycristallin, et elle est recouverte d'une métallisation opaque d'aluminium ou d'un matériau conducteur. Le masque optique est soit passif connecté à la masse, soit actif utilisé pour véhiculer des signaux de commande.

Par ailleurs, selon l'invention, on prévoit une structure d'évacuation des charges contenues dans les deuxième et troisième zones de stockage, c'est-à-dire sous les grilles G2 et G3 de la partie non masquée. Cette structure peut être constituée classiquement par
- une grille de réinitialisation AB adjacente d'un côté aux deuxième et troisième zones de stockage,
- un drain d'évacuation DR (typiquement une région diffusée dopée de type n+ portée à un potentiel d'alimentation positif, si les charges photogénérées sont des électrons) adjacent à la grille de réinitialisation de l'autre côté.

Le capteur comprend des moyens d'activation de la grille de réinitialisation AB pour la porter à un potentiel haut permettant de déclencher périodiquement une évacuation des charges de la partie non masquée vers le drain dans lequel ces charges disparaissent.

L'évacuation des charges est comprise ici comme étant une évacuation hors des zones de stockage ; les charges évacuées disparaissent de ces zones, elles sont perdues et non stockées, et elles ne font plus partie du processus de transfert et accumulation de charges.

L'architecture du capteur d'image TDI à transfert de charge comprend donc des pixels à plusieurs zones de stockage par pixel, qui sont définies par trois grilles dans le cas de la figure 1, et elle possède dans chaque pixel une partie masquée, une partie non masquée, et une structure d'évacuation de charges de toute la partie non masquée, avec les moyens de commande correspondants. La partie masquée réduit l'efficacité de conversion photoélectrique puisque la surface recueillant la lumière dans un pixel est alors plus petite que ce qu'elle pourrait être, mais l'avantage est que la durée d'intégration T_{INT} pour l'observation d'une ligne pendant une période de ligne T_{L} est alors réglable à volonté en choisissant l'instant et la durée d'activation de la grille de réinitialisation.

On notera par ailleurs que la grille de réinitialisation et le drain d'évacuation peuvent servir de système d'anti-éblouissement lorsque la grille n'est pas activée, en ce sens que le potentiel bas appliqué à la grille en dehors des périodes d'activation peut être ajusté à une valeur non nulle, par exemple légèrement positive, qui permet que les charges risquant de saturer les zones de stockage et de perturber les pixels voisins soient évacuées vers le drain avant cette saturation. Dans la suite on considèrera pour simplifier que le potentiel bas appliqué à la grille de réinitialisation en dehors des instants d'activation est un potentiel nul.

Le fonctionnement de ce capteur est fondé comme dans toutes les structures de transfert de charges sur la création de puits de potentiel pour stocker des charges et de barrières de potentiel autour des puits pour confiner les charges stockées. On supposera comme d'habitude que les charges générées sont des électrons, que les puits de potentiel sont donc créés par l'application de potentiels positifs sur une grille, et que les barrières de potentiel sont créées par l'application de potentiels nuls (ou en tout cas moins positifs que les potentiels qui créent les puits les plus profonds).

On se place d'abord dans une situation dans laquelle seules les grilles G3 (non masquées) reçoivent un potentiel positif et créent au-dessous de ces grilles un puits de potentiel retenant des charges ; ces charges sont à ce moment une accumulation de charges provenant de pixels situés en amont dans le sens du transfert de charges et ayant vu auparavant le même point d'image au cours de périodes d'observation précédentes ; les régions sous les grilles G2 et G1 (à un potentiel bas) constituent des barrières de potentiel confinant les charges sous les grilles G3. On commande alors les grilles des pixels pour avoir la succession d'étapes suivantes :
a) on applique un potentiel positif sur les grilles G1 pour créer un puits de potentiel (vide de charges), puis on abaisse le potentiel des grilles G3 : les charges présentes sous la grille G3 de chaque pixel se déversent à ce moment sous la grille G1 du pixel suivant (pixel aval) ;
b) on applique aux grilles AB un signal de réinitialisation RST qui est un potentiel positif d'activation de la structure d'évacuation, et on maintient ce potentiel pour empêcher toute accumulation de charges sous les grilles G2 et G3 pendant une durée choisie en fonction de la durée désirée T_{INT} d'intégration de charges dans les pixels pour une période de ligne T_{L} correspondant à la vitesse de défilement (T_{L} = D/V) ; les charges stockées ou créées sous les grilles G2 et G3 sont évacuées et perdues ; celles qui sont stockées sous les grilles G1 sont conservées ;
c) on arrête le signal RST de réinitialisation, ce qui définit le début de la durée d'intégration T_{INT} ;
d) l'intégration de charges photogénérées se produit sous les grilles transparentes G2 et G3 ;
e) on remonte le potentiel des grilles G2 pour que ces charges se stockent sous les grilles G2 ;
f) on abaisse ensuite le potentiel des grilles G1, de sorte que les charges stockées sous les grilles G1 passent sous les grilles adjacentes G2 et y restent ; le puits de potentiel sous les grilles G2 comprend alors les charges précédemment stockées sous les grilles G1 (étape a) et les charges générées actuellement par l'éclairement du pixel (étape e et suivantes) ;
g) on monte le potentiel des grilles G3 ; les charges se répartissent entre les grilles G2 et G3 ; l'accumulation de charges résultant de l'éclairement actuel des grilles G2 et G3 non masquées se poursuit sous ces grilles ;
h) on redescend le potentiel des grilles G2 et les charges se regroupent sous les grilles G3 et comprennent, outre les charges accumulées, les charges photogénérées sous les grilles G2 et G3 (non masquées) pendant la période d'observation courante ;
i) la fin de la période d'observation courante, donc la fin de la durée d'intégration T_{INT} se produit lorsqu'on remonte le potentiel des grilles G1 pour se retrouver dans l'étape a) d'une nouvelle période d'observation T_{L}. Les charges qui vont alors être déversées dans la grille G1 de chaque pixel incluent non seulement les accumulations précédentes des pixels situés en amont mais aussi les charges intégrées dans le pixel considéré au cours de la durée T_{INT} qui vient de s'écouler.

Si la fin de la période d'intégration de charges est définie comme l'instant auquel on remonte le potentiel des grilles G1, alors on voit qu'on a défini un début d'intégration à un moment qui est l'étape c, laquelle peut être définie à volonté, et non plus l'étape a) comme on l'aurait fait dans l'art antérieur. Ceci est possible parce qu'on a masqué la zone G1 (interdisant qu'elle continue à accumuler directement des charges) et qu'on a autorisé le vidage des charges sous les grilles G2 et G3 sans vider les charges sous les grilles G1.

La figure 2 représente le chronogramme de fonctionnement correspondant. Sa particularité par rapport au fonctionnement d'une structure TDI plus classique dont les pixels comporteraient également trois grilles, est la présence d'une commande RST de la grille AB, activée avant le début d'une durée d'intégration et interdisant donc l'intégration de charges, alors qu'une structure classique comporte une intégration pendant toute la durée d'observation de ligne T_{L} (période ligne).

Les signaux de ce chronogramme sont les suivants :
- signal Φ1 de commande des grilles G1
- signal Φ2 de commande des grilles G2
- signal Φ3 de commande des grilles G3
- signal RST de commande de la grille d'évacuation AB.

Les activations de ces signaux se produisent périodiquement (période T_{L}) dans l'ordre suivant, correspondant aux étapes a) à f) précédemment décrites :

### Etape a)

Le front de montée du signal Φ1 définit le début d'une période de ligne et crée un puits de potentiel sous les grilles G1.

Le front de descente du signal Φ3, légèrement postérieur au front de montée du signal Φ1, permet alors de déverser les charges de la grille G3 vers la grille G1 du pixel suivant. Ces charges sont les charges résultant de l'éclairement des pixels qui ont vu la même ligne d'image au cours des périodes précédentes.

### Etape b)

Le front de montée du signal RST, légèrement postérieur au front de descente du signal Φ3, permet de faire disparaître ensuite vers un drain les charges générées par la lumière sous les grilles éclairées G2 et G3.

### Etape c)

Le front de descente du signal RST permet d'autoriser une conservation des nouvelles charges générées sous les grilles G2 et G3 du pixel. C'est ce front de descente qui définit le début de l'intégration de charges photogénérées (Etape d).

### Etape e)

Le front de montée du signal Φ2, légèrement postérieur au front de descente du signal RST, crée un puits de potentiel permettant que les charges photogénérées sous les grilles G2 et G3 s'accumulent ensuite sous la grille G2.

### Etape f)

Le front de descente du signal Φ1, postérieur au front de montée du signal Φ2 permet que les charges stockées sous la grille G1 et résultant d'accumulations des périodes précédentes se déversent dans le puits de potentiel sous les grilles G2.

### Etape g)

Le front de montée du signal Φ3, postérieur au front de montée du signal Φ2, permet que les charges sous la grille G2 se répartissent sous les grilles G2 et G3.

### Etape h)

Le front de descente du signal Φ2, permet que les charges passent entièrement sous la grille G3.

### Etape i)

Le front de remontée du signal Φ1, qui définit le début d'une nouvelle période de ligne, crée un puits de potentiel dans lequel se déverseront ensuite les charges présentes sous la grille G3, résultant d'une part des accumulations précédentes et d'autre part de la génération de charges par la lumière dans le pixel courant au cours de la période qui vient de se dérouler.

On notera que le déversement de charges de la partie masquée vers la partie non masquée d'un pixel peut se faire à n'importe quel moment après la fin du signal d'activation RST de la structure d'évacuation de charges mais pas avant cette fin.

On comprendra que ce fonctionnement est facilement transposable si on change la nature des zones de stockage, c'est-à-dire notamment si certaines de celles-ci ne sont pas définies par des grilles comme dans l'exemple précédent mais par des photodiodes et notamment des photodiodes à potentiel de surface fixe ("pinned photodiodes"). De même, ce fonctionnement reste facilement transposable si les pixels comportent un nombre de régions de stockage différent de trois, pourvu qu'on maintienne le principe de la présente invention, à savoir la présence dans le pixel d'une subdivision masquée de la lumière et la présence d'une commande d'évacuation des charges générées dans l'autre subdivision qui reste éclairée. Enfin, le principe de l'invention est applicable aussi bien dans le cas de régions de stockage sous les grilles qui ont un profil de dopage constant que dans le cas de régions de stockage ayant des profils de dopage différent du côté amont et du côté aval comme cela est souvent fait pour réduire le nombre de phases de commande des grilles en introduisant une directionalité de transfert due à ces profils particuliers de dopage.

On va donner ci-après un exemple de fonctionnement de l'invention, avec un pixel comportant quatre grilles et deux photodiodes, réparties en deux subdivisions dont l'une est masquée et l'autre est éclairée.

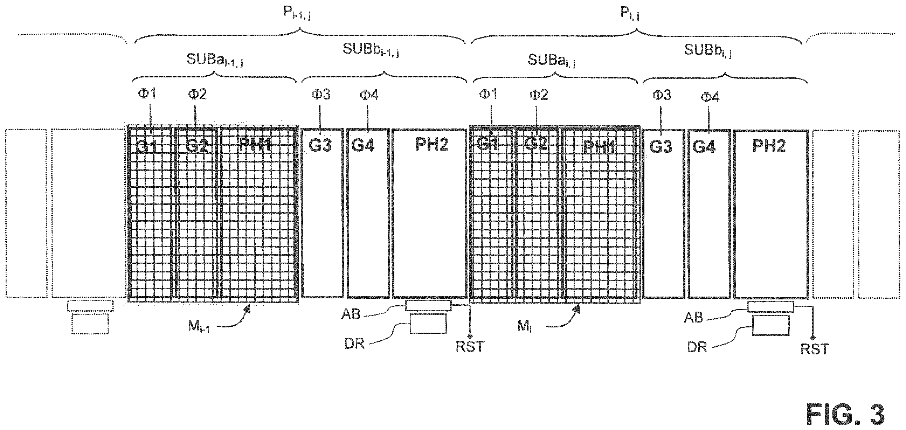

La figure 3 représente en vue dessus une colonne de pixels avec deux pixels consécutifs P_{i-1,j} et P_{i,j} de rang i-1 et i respectivement. Les pixels comportent chacun deux subdivisions repérées par l'indice a et b respectivement, à savoir SUBa_{i-1,j} et SUBb_{i-1,j} d'une part, et SUBa_{i,j} et SUBb_{i,j} d'autre part. La première subdivision de chaque pixel est masquée par un masque, Mᵢ₋₁ pour le pixel P_{i-1,j} et Mᵢ pour le pixel P_{i,j}. Les masques sont représentés par des zones quadrillées laissant apparaître les grilles et photodiodes qui constituent cette subdivision du pixel.

La première subdivision comporte successivement deux grilles G1 et G2 et une photodiode PH1. Les grilles comme la photodiode définissent des régions de stockage de charges. La deuxième subdivision comporte successivement deux grilles G3 et G4 et une photodiode PH2. Un transfert de charges est possible entre deux grilles successives ou entre une grille et une photodiode qui la suit ou entre une photodiode et la grille qui la suit.

Les grilles G1, G2, G3, G4 sont commandées par des signaux logiques Φ1, Φ2, Φ3, Φ4 respectivement. Les photodiodes ne sont pas commandées, elles sont de préférence des photodiodes de type "pinned" dont le potentiel de surface est nul par construction et qui établissent un puits de potentiel intrinsèque pouvant recueillir des charges. Bien entendu, une structure avec des photodiodes à potentiel de surface commandé pourrait être envisagée également.

Une grille de réinitialisation et un drain d'évacuation de charges associées à la subdivision non masquée sont prévus comme dans le pixel de la figure 1 ; cette grille et ce drain sont associés à la photodiode PH2 ; la grille de réinitialisation, commandée par un signal d'activation RST, est donc adjacente à la photodiode. Il n'est pas nécessaire de prévoir que la grille de réinitialisation soit directement adjacente aux grilles G3 et G4 de la subdivision non masquée car le moment d'activation de cette grille interviendra à un moment où toutes les charges qui auront pu être stockées sous les grilles G3 et G4 auront déjà été transférées dans la photodiode PH2.

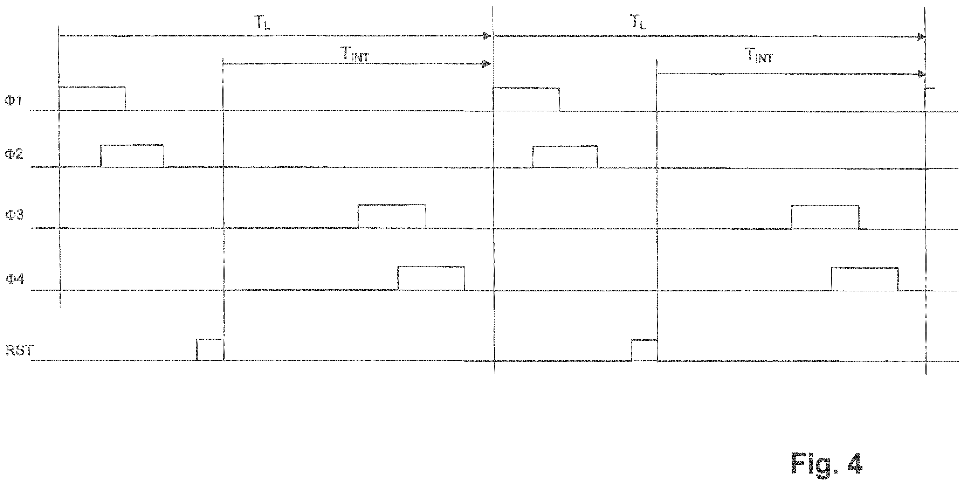

Le fonctionnement est le suivant, expliqué en référence au chronogramme de la figure 4 qui représente les différents signaux Φ1, Φ2, Φ3, Φ4 et RST qui ont là encore une périodicité d'un temps de ligne T_{L} = D/V mais une durée d'intégration T_{INT} qui peut être inférieure à T_{L} et qui est définie par l'instant de fin du signal RST d'activation de l'évacuation.

Le début de la période de ligne peut être défini comme étant le front de montée du signal Φ1, à un moment où toutes les autres grilles sont au niveau bas ; les charges accumulées dans la photodiode PH2 du pixel précédent se déversent sous la grille G1. Ces charges sont celles qui résultent des accumulations dans les pixels précédents qui ont vu la même ligne d'image.

Le front de montée du signal Φ2 répartit alors ces charges entre les grilles G1 et G2.

Le front de descente du signal Φ1 concentre ces charges sous la grille G2.

Le front de descente du signal Φ2 déverse ces charges dans la photodiode PH1.

Le front de montée du signal RST vide les charges qui ont pu être accumulées dans la photodiode non masquée PH2 et maintient leur évacuation pendant la durée d'activation de RST. Ce signal n'agit pas sur la photodiode masquée et ne modifie donc pas la quantité de charges qu'elle contient.

Le front de descente du signal RST définit le début du temps d'intégration effectif T_{INT} car il autorise alors une accumulation de charges dans la photodiode PH2, résultant de l'éclairement de cette photodiode et de l'éclairement des grilles G3 et G4. Ces dernières sont à un potentiel bas et les charges qu'elles génèrent se déversent aussitôt dans la photodiode PH2. On note qu'il est possible de prévoir un dopage de semi-conducteur sous la grille G3 légèrement différent du dopage sous la grille G4, pour faciliter le déversement de leurs charges vers la photodiode PH2.

L'accumulation de charges de l'éclairement courant du pixel continue alors dans la photodiode PH2.

Avant la fin de la période de ligne, les signaux sont les suivants :
- le front de montée de Φ3 crée sous la grille G3 un puits de potentiel dans lequel se déversent les charges de la photodiode PH1 (charges résultant des éclairements de pixels précédents) ; les charges résultant de l'éclairement actuel se dirigeront également sous la grille G3 ;
- le front de montée de Φ4 définit sous la grille G4 un autre puits de potentiel et les charges se répartissent sous les grilles G3 et G4 ;
- le front de descente de Φ3 concentre ces charges sous la grille G4.
- enfin, le front de descente de Φ4 déverse ces charges dans la photodiode PH2 qui contient alors la somme des charges des éclairements des pixels précédents et de l'éclairement actuel du pixel.

Dans la réalisation de la figure 1 on a considéré que la grille masquée G1 a la même dimension que les grilles non masquées. Il est possible de prévoir qu'elle a une dimension plus faible (pour éviter une trop grande réduction de la surface photosensible du pixel) mais on doit évidemment s'assurer que la capacité de stockage de charges sous cette grille est suffisante pour recueillir toutes les charges de N pixels ayant vu un même point d'image.

De même, dans la réalisation de la figure 2, on a considéré que les deux subdivisions du pixel avaient la même dimension, mais on peut prévoir une dimension de la zone masquée plus petite que celle de la zone non masquée, toujours avec la condition que les grilles et les photodiodes aient une capacité de stockage de charges suffisante par rapport aux besoins (selon le nombre de lignes et selon la gamme d'éclairements envisagés).

## Revendications

1. Capteur d'image à transfert de charges fonctionnant en défilement et intégration de charges, le capteur d'image comportant N lignes adjacentes de P pixels en vue d'une observation d'une même ligne d'image successivement par plusieurs lignes de pixels avec une sommation des charges électriques générées par un point d'image pendant une durée périodique de ligne (T_{L}) dans les pixels de même rang des différentes lignes, les pixels comportant chacun une succession, dans le sens du défilement, de zones de stockage de charges dont certaines sont photosensibles, le capteur d'image comportant des moyens de commande pour appliquer à ces zones des potentiels permettant le stockage puis le transfert directionnel de charges d'un pixel au suivant, **caractérisé en ce que** chaque pixel est subdivisé,
dans le sens du défilement, en au moins deux parties adjacentes (SUBa_{i,j}, SUBb_{i,j}), chaque partie comportant au moins une zone de stockage de charges indépendante des zones de stockage de l'autre partie mais permettant un transfert de charges de la première partie vers la deuxième, l'une des parties (SUBa_{i,j}) étant masquée contre la lumière, et l'autre partie (SUBb_{i,j}) n'étant pas masquée contre la lumière, cette dernière comprenant au moins une zone de stockage photosensible (G3, G4, PH2) et une structure d'évacuation de charges (AB, DR) permettant de supprimer les charges stockées dans cette autre partie, le capteur d'image comprenant des moyens pour activer la structure d'évacuation au cours d'une fraction d'une durée de ligne (T_{L}), avant un instant réglable de début d'intégration effective précédant une étape de transfert de charges de la partie masquée vers la partie non masquée.

2. Capteur d'image selon la revendication 1, **caractérisé en ce que** le pixel comporte trois grilles adjacentes se succédant dans le sens du défilement, la première grille (G1) étant masquée de la lumière et constituant la première partie du pixel et les deux autres(G2, G3) étant éclairées et constituant la deuxième partie du pixel, la structure d'évacuation de charges étant adjacente auxdites deux autres grilles (G2, G3).

3. Capteur d'image selon la revendication 1, **caractérisé en ce que** la première partie du pixel comporte successivement, dans le sens du défilement, deux grilles (G1, G2) et une photodiode (PH1), et la deuxième partie comporte également deux grilles (G3, G4) et une photodiode (PH2), et la structure d'évacuation de charges est adjacente à la photodiode (PH2) de la deuxième partie.

4. Procédé de fonctionnement d'un capteur d'image à transfert de charges, comme défini dans la revendication 1, fonctionnant en défilement et intégration de charges, le capteur d'image comportant N lignes adjacentes de P pixels en vue d'une observation d'une même ligne d'image successivement par plusieurs lignes de pixels avec une sommation des charges électriques générées par un point d'image pendant une durée de ligne (T_{L}) dans les pixels de même rang des différentes lignes, les pixels comportant chacun une succession, dans le sens du défilement, de zones de stockage de charges dont certaines sont photosensibles, le capteur d'image comportant des moyens de commande pour appliquer à ces zones des potentiels permettant le stockage puis le transfert directionnel de charges d'un pixel amont vers un pixel aval, **caractérisé en ce qu'**une partie des zones de stockage de chaque pixel est masquée de la lumière et une autre partie est non masquée et est photosensible, et **en ce que** le défilement et l'intégration de charges comprennent, cycliquement avec une périodicité égale à une durée de ligne T_{L}:
- le déversement de charges issues du pixel amont dans une zone de stockage de la partie masquée du pixel aval,
- une commande de vidage, vers un drain d'évacuation, des charges contenues dans la partie non masquée du pixel aval, puis l'interruption de cette commande, définissant un instant de début d'intégration effective de charges dans le pixel aval,
- simultanément ou séparément, l'intégration de charges photogénérées dans la partie non masquée du pixel aval et le déversement vers la partie non masquée des charges stockées dans la partie masquée du pixel aval.

## Patentansprüche

1. Ladungsübertragungs-Bildsensor, arbeitend mit Durchlauf und Integration von Ladungen, wobei der Bildsensor N aneinandergrenzende Zeilen mit P Pixeln zur Beobachtung einer selben Bildzeile nacheinander durch mehrere Pixel-Zeilen mit einer Summierung der durch einen Bildpunkt über eine periodische Zeilendauer (T_{L}) in den Pixeln gleichen Ranges der unterschiedlichen Zeilen erzeugten elektrischen Ladungen, wobei die Pixel jeweils eine Abfolge in der Durchlaufrichtung von Ladungsspeicherbereichen beinhalten, worunter einige lichtempfindlich sind, wobei der Bildsensor Steuerungsmittel beinhaltet, um an diese Bereiche Potenziale anzulegen, welche die Speicherung und anschließend die gerichtete Übertragung von Ladungen eines Pixels an den nächsten ermöglichen, **dadurch gekennzeichnet, dass** jeder Pixel in der Durchlaufrichtung in mindestens zwei aneinandergrenzende Abschnitte (SUBa_{i,j}, SUBb_{i,j}) unterteilt ist, wobei jeder Abschnitt mindestens einen Speicherbereich von Ladungen besitzt, welcher unabhängig von den Speicherbereichen des anderen Abschnittes ist, jedoch eine Übertragung von Ladungen vom ersten Abschnitt an den zweiten ermöglicht, wobei einer der Abschnitte (SUBa_{i,j}) gegenüber Licht maskiert ist, und der andere Abschnitt (SUBb_{i,j}) nicht gegenüber Licht maskiert ist, wobei letzterer mindestens einen lichtempfindlichen Speicherbereich (G3, G4, PH2) und eine Ladungsableitungsstruktur (AB, DR) beinhaltet, welche es ermöglicht, die in dem anderen Abschnitt gespeicherten Ladungen zu beseitigen, wobei der Bildsensor Mittel zum Aktivieren der Ableitungsstruktur im Zuge eines Bruchteils einer Zeilendauer (T_{L}) beinhaltet, vor einem einstellbaren Anfangszeitpunkt der effektiven Integration, welcher einem Schritt der Ladungsübertragung von dem maskierten Abschnitt an den unmaskierten Abschnitt vorausgeht.

2. Bildsensor nach Anspruch 1, **dadurch gekennzeichnet, dass** der Pixel drei aneinandergrenzende Gitter beinhaltet, welche einander in der Durchlaufrichtung folgen, wobei das erste Gitter (G1) gegenüber Licht maskiert ist und den ersten Abschnitt des Pixels bildet und die beiden anderen (G2, G3) beleuchtet werden und den zweiten Abschnitt des Pixels bilden, wobei die Ladungsableitungsstruktur an die beiden anderen Gitter (G2, G3) angrenzt.

3. Bildsensor nach Anspruch 1, **dadurch gekennzeichnet, dass** der erste Abschnitt des Pixels nacheinander in der Durchlaufrichtung zwei Gitter (G1, G2) und eine Photodiode (PH1) beinhaltet, und der zweite Abschnitt ebenfalls zwei Gitter (G3, G4) und eine Photodiode (PH2) beinhaltet, und die Ladungsableitungsstruktur an die Photodiode (PH2) des zweiten Abschnitts angrenzt.

4. Verfahren zum Betreiben eines Ladungsübertragungs-Bildsensors laut Definition von Anspruch 1, arbeitend mit Durchlauf und Integration von Ladungen, wobei der Bildsensor N aneinandergrenzende Zeilen mit P Pixeln zur Beobachtung einer selben Bildzeile nacheinander durch mehrere Pixel-Zeilen mit einer Summierung der durch einen Bildpunkt über eine Zeilendauer (T_{L}) in den Pixeln gleichen Ranges der unterschiedlichen Zeilen erzeugten elektrischen Ladungen, wobei die Pixel jeweils eine Abfolge in der Durchlaufrichtung von Ladungsspeicherbereichen beinhalten, worunter einige lichtempfindlich sind, wobei der Bildsensor Steuerungsmittel beinhaltet, um an diese Bereiche Potenziale anzulegen, welche die Speicherung und anschließend die gerichtete Übertragung von Ladungen eines vorgelagerten Pixels an einen nachgelagerten Pixel ermöglichen, **dadurch gekennzeichnet, dass** ein Abschnitt der Speicherbereiche eines jeden Pixels gegenüber Licht maskiert ist und ein anderer Abschnitt nicht maskiert und lichtempfindlich ist, und dadurch, dass der Durchlauf und die Integration von Ladungen zyklisch und mit einer Periodizität gleich einer Zeilendauer T_{L} Folgendes beinhalten:
- das Ablassen von Ladungen, welche aus dem vorgelagerten Pixel stammen, in einen Ladungsspeicherbereich des maskierten Abschnittes des nachgelagerten Pixels,
- einen Entleerungsbefehl, an einen Ableitungs-Drain, der in dem nicht maskierten Abschnitt des nachgelagerten Pixels enthaltenen Ladungen, gefolgt von der Unterbrechung dieses Befehls, welche einen Anfangszeitpunkt der effektiven Integration von Ladungen im nachgelagerten Pixel definiert,
- gleichzeitig oder separat, die Integration von durch Licht erzeugten Ladungen in dem nicht maskierten Abschnitt des vorgelagerten Pixels und das Ablassen an den nicht maskierten Abschnitt der in dem maskierten Abschnitt des vorgelagerten Pixels gespeicherten Ladungen.

## Claims

1. A charge-coupled image sensor operating with scrolling and charge integration, the image sensor comprising N adjacent rows of P pixels for observation of one and the same image strip by multiple rows of pixels in succession with summation of the electric charge generated by an image point, for a periodic row duration (T_{L}), in the pixels of the same rank of the various rows, the pixels each comprising a succession, in the direction of movement, of charge storage areas, some of which are photosensitive, the image sensor comprising control means for applying potentials to these areas allowing the storage followed by the directional transfer of charge from one pixel to the next, **characterized in that** each pixel is subdivided, in the direction of scrolling, into at least two adjacent portions (SUBa_{i,j}, SUBb_{i,j}), each portion comprising at least one charge storage area that is independent of the storage areas of the other portion while allowing a transfer of charge from the first portion to the second, one of the portions (SUBa_{i,j}) being masked against light and the other portion (SUBb_{i,j}) not being masked against light, the latter comprising at least one photosensitive storage area (G3, G4, PH2) and a charge removal structure (AB, DR) allowing the charge stored in this other part to be removed, the image sensor comprising means for activating the removal structure for a fraction of a row duration (T_{L}), before an adjustable instant in time of the start of actual integration preceding a step of transferring charge from the masked area to the unmasked area.

2. The image sensor of Claim 1, **characterized in that** the pixel comprises three adjacent gates coming one after the other in the direction of movement, the first gate (G1) being masked from light and forming the first portion of the pixel and the other two (G2, G3) being lit and forming the second portion of the pixel, the charge removal structure being adjacent to said other two gates (G2, G3).

3. The image sensor of Claim 1, **characterized in that** the first portion of the pixel comprises in succession, in the direction of movement, two gates (G1, G2) and a photodiode (PH1), and the second portion also comprises two gates (G3, G4) and a photodiode (PH2), and the charge removal structure is adjacent to the photodiode (PH2) of the second portion.

4. An operating method for a charge-coupled image sensor, according to claim 1, operating with scrolling and charge integration, the image sensor comprising N adjacent rows of P pixels for observation of one and the same image strip by multiple rows of pixels in succession with summation of the electric charge generated by an image point, for a row duration (T_{L}), in the pixels of the same rank of the various rows, the pixels each comprising a succession, in the direction of movement, of charge storage areas, some of which are photosensitive, the image sensor comprising control means for applying potentials to these areas allowing the storage followed by the directional transfer of charge from an upstream pixel to a downstream pixel, **characterized in that** a portion of the storage areas of each pixel is masked from light and another portion is not masked and is photosensitive, and **in that** the scrolling and integration of charge comprise, cyclically with a periodicity equal to one row duration T_{L}:
- the transfer of charge arising from the upstream pixel to a storage area of the masked portion of the downstream pixel;
- a command to empty, towards a removal drain, the charge contained in the unmasked portion of the downstream pixel, followed by the cessation of this command, defining an instant in time of the start of actual charge integration in the downstream pixel;
- simultaneously or separately, the integration of photogenerated charge in the unmasked portion of the downstream pixel and the transfer of the charge stored in the masked portion of the downstream pixel to the unmasked portion.
